# EUROPEAN PATENT APPLICATION

(11) **EP 4 761 038 A1**
(43) Date of publication of application: **17.06.2026**
(21) Application number: 24874940.0
(22) Date of filing: 02.10.2024
(51) Int. Cl.: H02J 7/00, B60L 58/16, G01R 31/392, G01R 31/385, H01M 10/48

(54) **BATTERY MANAGEMENT APPARATUS AND OPERATION METHOD THEREFOR**

(30) Priority: 05.10.2023 KR 20230132823
(71) Applicant: LG Energy Solution, Ltd., Seoul 07335 (KR)
(72) Inventor: LEE, Jeong Gon, Daejeon 34122 (KR); YI, Jae Shin, Daejeon 34122 (KR)
(74) Representative: Plasseraud IP
(86) International application number: PCT/KR2024/014953
(87) International publication number: WO 2025/075384

(57) **Abstract**

A battery management apparatus according to an embodiment disclosed herein includes an obtaining unit configured to obtain a voltage of a battery cell and a controller configured to calculate a battery profile related to a capacity and the voltage of the battery cell, based on the voltage of the battery cell, identify degradation states of a positive electrode and a negative electrode of the battery cell, by using the battery profile, and manage a charging profile used for charging of the battery cell based on the degradation states of the positive electrode and the negative electrode.

## Description

### TECHNICAL FIELD

### CROSS-REFERENCE TO RELATED APPLICATION

This application claims priority to and the benefit of Korean Patent Application No. 10-2023-0132823 filed in the Korean Intellectual Property Office on October 5, 2023, the entire content of which is incorporated herein by reference.

### TECHNICAL FIELD

Embodiments disclosed herein relate to a battery management apparatus and an operating method thereof.

### BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Recently, the lithium-ion battery is attracting attention as a next-generation energy storage medium as a usage range thereof is expanded to a power source of electric vehicles.

An electric vehicle is supplied with electricity from outside to charge a battery cell, and then the battery cell is discharged to drive a motor and obtain power. The battery cell undergoes internal deformation and denaturation through various charges/discharges in production and use phases, such that physical and chemical characteristics thereof change. For example, venting due to internal short-circuit, external short-circuit, and lithium precipitation or an under-voltage defect in which a voltage of a battery cell decreases below a certain level may occur. A technique for managing a charging operation of the battery cell due to degradation and deterioration of a battery is required.

### DISCLOSURE

### TECHNICAL PROBLEM

Embodiments disclosed herein aim to provide a battery management apparatus and an operating method thereof in which a charging profile of a battery cell is managed based on degradation states of a positive electrode and a negative electrode of a battery cell.

Embodiments disclosed herein aim to provide a battery management apparatus and an operating method thereof in which a fast charging profile for preventing degradation of a battery cell is improved based on degradation states of a positive electrode and a negative electrode of the battery cell.

Technical problems of the embodiments disclosed herein are not limited to the above-described technical problems, and other unmentioned technical problems would be clearly understood by one of ordinary skill in the art from the following description.

### TECHNICAL SOLUTION

A battery management apparatus according to an embodiment disclosed herein includes an obtaining unit configured to obtain a voltage of a battery cell and a controller configured to calculate a battery profile related to a capacity and the voltage of the battery cell, based on the voltage of the battery cell, identify degradation states of a positive electrode and a negative electrode of the battery cell, by using the battery profile, and manage a charging profile used for charging of the battery cell based on the degradation states of the positive electrode and the negative electrode.

According to an embodiment, the controller may be further configured to calculate a positive electrode degradation degree that is a degree to which the positive electrode of the battery cell is degraded and a negative electrode degradation degree that is a degree to which the negative electrode of the battery cell is degraded, based on the battery profile and identify the degradation states of the positive electrode and the negative electrode based on the positive electrode degradation degree and the negative electrode degradation degree.

According to an embodiment, the controller may be further configured to separate a positive electrode profile and a negative electrode profile from the battery profile and calculate the positive electrode degradation degree and the negative electrode degradation degree based on a degree to which capacities of the positive electrode profile and the negative electrode profile are reduced in comparison to capacities of a reference positive electrode profile and a reference negative electrode profile.

According to an embodiment, the controller may be further configured to determine a main degradation state that has a greater influence upon degradation of the battery cell between the degradation states of the positive electrode and the negative electrode of the battery cell and manage the charging profile based on the main degradation state.

According to an embodiment, the controller may be further configured to determine, as the main degradation state, a degradation state of an electrode having a greater degradation degree between the positive electrode degradation degree and the negative electrode degradation degree.

According to an embodiment, the controller may be further configured to manage a charging profile used for charging of the battery cell based on a first charging profile related to the battery cell, when the main degradation state is the degradation state of the positive electrode.

According to an embodiment, the first charging profile may include a charging profile related to a beginning of life (BoL) state of the battery cell.

According to an embodiment, the controller may be further configured to manage a charging profile used for charging of the battery cell based on a second charging profile that reflects the degradation state of the negative electrode when the main degradation state is the degradation state of the negative electrode.

According to an embodiment, the controller may be further configured to calculate, based on the first charging profile indicating a charging current corresponding to the capacity of the battery cell related to the BoL state of the battery cell, the second charging profile by reducing the charging current of the first charging profile by the negative electrode degradation degree.

According to an embodiment, the controller may be further configured to calculate, based on the first charging profile indicating a charging current corresponding to the capacity of the battery cell related to the BoL state of the battery cell, the second charging profile by reducing the capacity of the first charging profile by the negative electrode degradation degree.

According to an embodiment, the charging profile may indicate a correspondence between the capacity and the charging current of the battery cell for fast charging of the battery cell.

A battery management method according to an embodiment disclosed herein includes calculating a battery profile related to a capacity and a voltage of a battery cell, based on the voltage of the battery cell, identifying degradation states of a positive electrode and a negative electrode of the battery cell, by using the battery profile, and managing a charging profile used for charging of the battery cell based on the degradation states of the positive electrode and the negative electrode.

According to an embodiment, the identifying of the degradation states of the positive electrode and the negative electrode of the battery cell may include calculating a positive electrode degradation degree that is a degree to which the positive electrode of the battery cell is degraded and a negative electrode degradation degree that is a degree to which the negative electrode of the battery cell is degraded, based on the battery profile and identifying the degradation states of the positive electrode and the negative electrode based on the positive electrode degradation degree and the negative electrode degradation degree.

According to an embodiment, the calculating of the positive electrode degradation degree and the negative electrode degradation degree may include separating a positive electrode profile and a negative electrode profile from the battery profile and calculating the positive electrode degradation degree and the negative electrode degradation degree based on a degree to which capacities of the positive electrode profile and the negative electrode profile are reduced in comparison to capacities of a reference positive electrode profile and a reference negative electrode profile.

According to an embodiment, the managing of the charging profile may include determining a main degradation state that has a greater influence upon degradation of the battery cell between the degradation states of the positive electrode and the negative electrode of the battery cell and managing the charging profile based on the main degradation state.

According to an embodiment, the determining of the main degradation state may include determining, as the main degradation state, a degradation state of an electrode having a greater degradation degree between the positive electrode degradation degree and the negative electrode degradation degree.

According to an embodiment, the managing of the charging profile may include managing a charging profile used for charging of the battery cell based on a first charging profile related to the battery cell, when the main degradation state is the degradation state of the positive electrode.

According to an embodiment, the managing of the charging profile may include managing a charging profile used for charging of the battery cell based on a second charging profile that reflects the degradation state of the negative electrode when the main degradation state is the degradation state of the negative electrode.

According to an embodiment, the battery management method may further include calculating, based on the first charging profile indicating a charging current corresponding to the capacity of the battery cell related to the BoL state of the battery cell, the second charging profile by reducing the charging current of the first charging profile by the negative electrode degradation degree.

According to an embodiment, the battery management method may further include calculating, based on the first charging profile indicating a charging current corresponding to the capacity of the battery cell related to the BoL state of the battery cell, the second charging profile by reducing the capacity of the first charging profile by the negative electrode degradation degree.

### ADVANTAGEOUS EFFECTS

A battery management apparatus and an operating method thereof according to an embodiment disclosed herein may manage a charging profile of a battery cell based on degradation states of a positive electrode and a negative electrode of the battery cell.

The battery management apparatus and the operating method thereof according to an embodiment disclosed herein may improve a fast charging profile to prevent degradation of a battery cell based on degradation states of a positive electrode and a negative electrode of the battery cell.

In addition, various effects identified directly or indirectly through this document may be provided.

### DESCRIPTION OF DRAWINGS

FIG. 1 shows a battery cell pack according to an embodiment disclosed herein.
FIG. 2 is a block diagram of a battery management apparatus according to an embodiment disclosed herein.
FIG. 3 shows a battery profile according to an embodiment disclosed herein.
FIG. 4 shows a battery profile according to an embodiment disclosed herein.
FIG. 5 shows a battery profile according to an embodiment disclosed herein.
FIG. 6 shows a battery profile according to an embodiment disclosed herein.
FIG. 7 shows a charging profile according to an embodiment disclosed herein.
FIGS. 8 and 9 show a charging profile according to an embodiment disclosed herein.
FIG. 10 is an operating flowchart of a battery management apparatus according to an embodiment disclosed herein.
FIG. 11 is an operating flowchart of a battery management apparatus according to an embodiment disclosed herein.
FIG. 12 is a block diagram showing a hardware configuration of a computing system for performing an operating method of a battery management apparatus, according to an embodiment disclosed herein.

### MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments of the disclosure, operations performed by a module, a program, or other components may be executed sequentially, in parallel, repeatedly, or heuristically, or one or more of the operations may be executed in a different order or omitted, or one or more other operations may be added.

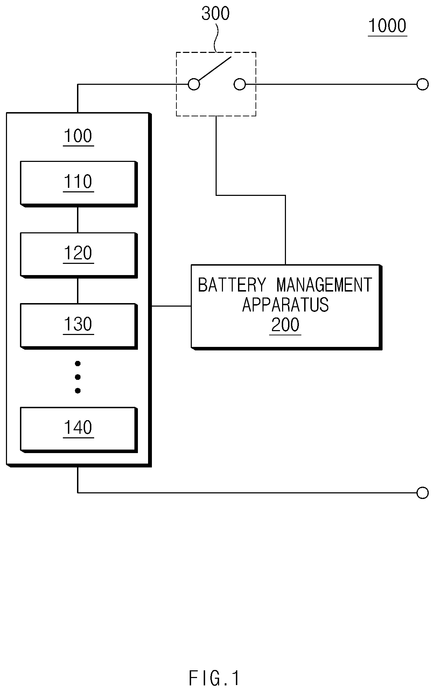

FIG. 1 shows a battery cell pack according to an embodiment disclosed herein.

Referring to FIG. 1, a battery cell pack 1000 according to an embodiment disclosed herein may include a battery cell module 100, a battery management apparatus 200, and a relay 300. According to various embodiments, the battery cell module 100 may be a battery cell, and in this case, the battery cell pack 1000 may have a cell-to-pack structure.

Meanwhile, although one battery cell module 100 is illustrated in FIG. 1, the battery cell module 100 may be configured in plural and the battery cell pack 1000 may have a stacked structure of a plurality of battery cell modules, according to an embodiment.

The battery cell module 100 may include a plurality of battery cells 110, 120, 130, and 140. Although the plurality of battery cells are illustrated as four in FIG. 1, the present disclosure is not limited thereto, and the battery cell module 100 may include n battery cells (n is a natural number equal to or greater than 2).

The battery cell module 100 may supply power to a target device (not shown). To this end, the battery cell module 100 may be electrically connected to the target device. Herein, the target device may include an electrical, electronic, or mechanical device that operates by receiving power from the battery cell pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery cell available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery cell module 100 is illustrated in FIG. 1, the battery cell module 100 may be configured in plural according to an embodiment.

The battery management apparatus 200 may manage and/or control a state and/or an operation of the battery cell module 100. For example, the battery management apparatus 200 may manage and/or control the states and/or operations of the plurality of battery cells 110, 120, 130, and 140 included in the battery cell module 100. The battery management apparatus 200 may manage charging and/or discharging of the battery cell module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery cell pack 1000.

In addition, the battery management apparatus 200 may monitor a voltage, a current, a temperature, etc., of the battery cell module 100 and/or each of the plurality of battery cells 110, 120, 130, and 140 included in the battery cell module 100. A sensor or various measurement modules for monitoring performed by the battery management apparatus 200, which are not shown, may be additionally installed in the battery cell module 100, a charging/discharging path, any position of the battery cell module 100, etc. The battery management apparatus 200 may calculate a parameter indicating a state of the battery cell module 100, e.g., a state of charge (SoC), a state of health (SoH) etc., based on a measurement value such as monitored voltage, current, temperature, etc.

For the battery cell module 100 and the plurality of battery cells 110, 120, 130, and 140, as a period of use or the number of times of use increases, a capacity may decrease, internal resistance may increase, and various factors of the battery may change. The battery management apparatus 200 may diagnose an abnormal phenomenon inside the battery cell module 100 and the plurality of battery cells 110, 120, 130, and 140 based on data of various factors changing with deterioration and degradation of the battery cells.

The battery management apparatus 200 may be one of various electronic devices for managing, diagnosing, or testing a battery. For example, the battery management apparatus 200 may be included in a battery management system (BMS) in and outside a vehicle, or may be implemented as a separate external device different from the BMS in the vehicle. According to an embodiment, the battery management apparatus 200 may be included in an apparatus for a charging/discharging test such as a server, a cloud server, or a charging/discharging cycler or may be included in various devices for diagnosing or testing the battery.

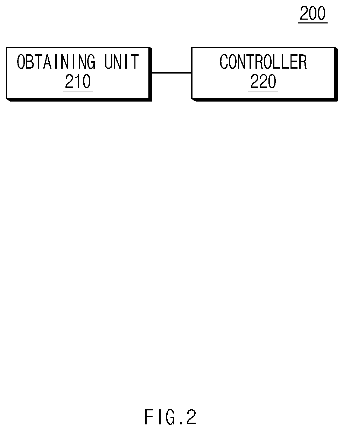

FIG. 2 is a block diagram of a battery management apparatus according to an embodiment disclosed herein.

Referring to FIG. 2, the battery management apparatus 200 may include a obtaining unit 210 and a controller 220. However, without being limited thereto, some components may be omitted from the battery management apparatus 200 or other general-purpose components may be further included in the battery management apparatus 200.

The obtaining unit 210 may obtain state information of each of the plurality of battery cells 110, 120, 130, and 140. For example, the obtaining unit 210 may monitor a voltage, a current, a temperature, etc., of each of the plurality of battery cells 110, 120, 130, and 140.

The controller 220 may control an operation of the battery management apparatus 200. According to an embodiment, the controller 220 may calculate parameters (e.g., a state of charge (SOC), a state of health (SOH), and/or a capacity) indicating a state of each of the plurality of battery cells 110, 120, 130, and 140 based on a voltage, a current, a temperature, etc., of each of the plurality of battery cells 110, 120, 130, and 140, obtained by the obtaining unit 210. The controller 220 may control an operation of each of the plurality of battery cells 110, 120, 130, and 140 based on the calculated SOC, SOH, capacity, etc.

The controller 220 may control the operation of each of the plurality of battery cells 110, 120, 130, and 140 to manage each of the plurality of battery cells 110, 120, 130, and 140. According to an embodiment, the controller 220 may manage charging and/or discharging of the plurality of battery cells 110, 120, 130, and 140.

According to an embodiment, the controller 220 may identify a degradation state of each of the plurality of battery cells 110, 120, 130, and 140 and manage charging of each of the plurality of battery cells 110, 120, 130, and 140 based on the degradation state. Herein, a degradation state of a battery cell may mean deterioration and/or degradation of a battery due to charging and discharging of the battery cell. According to an embodiment, the controller 220 may identify the degradation state of each of the plurality of battery cells 110, 120, 130, and 140 and manage a charging profile used for charging of each of the plurality of battery cells 110, 120, 130, and 140 according to a degree of degradation.

The battery cell 110 may undergo degradation and/or deterioration while being charged and discharged repeatedly. For example, in a positive electrode of the battery cell 110, a positive electrode active material may collapse or by-products may be generated due to charging and discharging. In a negative electrode of the battery cell 110, lithium (Li) plating may occur in which metal lithium is precipitated. In addition, an electrolyte of the battery cell 110 may be oxidized or a crystalline structure may be destroyed.

The degradation and deterioration of the battery cell 110 may affect performance of the battery cell 110 in comparison to an initial state of production of the battery cell 110. The degradation and deterioration of the battery cell 110 may also affect charging performance. The battery management apparatus 200 including the controller 220 identify and diagnose a degradation state of each of the plurality of battery cells 110, 120, 130, and 140. In addition, the controller 220 may manage charging of the battery cell 110 based on the state of the degraded battery cell 110 to lower a degradation speed of the battery cell 110. For example, the controller 220 may maintain or change a charging profile based on a degradation state of the battery cell 110, thereby managing the lifetime of the battery cell 110.

The controller 220 may have a structure for executing instructions that implement the operations of the battery management apparatus 200. The controller 220 may be implemented with an array of multiple logic gates or a general-purpose microprocessor for processing various operations, and may include a single processor or a plurality of processors. For example, the controller 220 may be implemented in the form of at least one of a microprocessor, a CPU, a GPU, and an AP.

The processor 220 may be configured separately from or integrally with a memory and/or a storage configured to store instructions, and may process various operations by executing the instructions stored in the memory and/or the storage. The memory and/or the storage may store various data, instructions, mobile applications, computer programs, etc. For example, the memory and/or storage may be implemented in the form of a non-volatile memory device such as ROM, PROM, EPROM, EEPROM, flash memory, PRAM, MRAM, RRAM, FRAM, etc., or a volatile memory device such as DRAM, SRAM, SDRAM, PRAM, RRAM, FeRAM, HDD, SSD, SD, Micro- SD, etc., or may be implemented in the form of a combination thereof.

The controller 220 may provide a user with information about the degradation state or charging profile of each of the plurality of battery cells 110, 120, 130, and 140. For example, the controller 220 may provide information about the degradation state or charging profile to a user terminal through a communication unit (not shown) and also provide the information about the degradation state or charging profile through a display provided in a vehicle, a charger, etc.

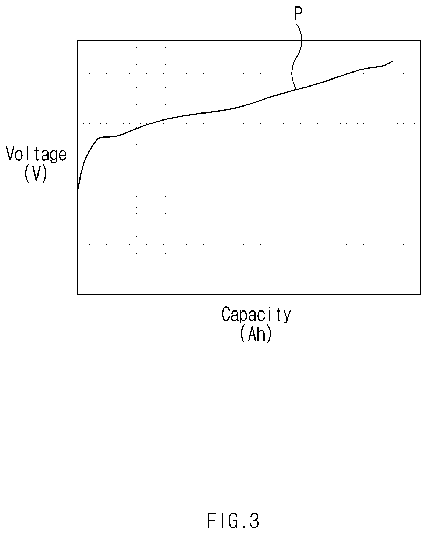

FIG. 3 shows a battery profile according to an embodiment disclosed herein.

Hereinbelow, for convenience of a description, an operation of the controller 220 will be described with reference to the battery cell 110, but the present disclosure is not limited thereto, and the operation of the controller 220 may be identically applied to the battery cell module 100 and the plurality of battery cells 110, 120, 130, and 140.

Referring to FIG. 3, the controller 220 may calculate a battery profile P related to the battery cell 110 based on information about the battery cell 110 including the voltage, current, temperature, etc., obtained in the obtaining unit 210. Herein, the battery profile P may include a profile based on a parameter (e.g., SOC, SOH, and/or capacity) indicating a state of the battery cell 110.

According to an embodiment, the controller 220 may calculate a capacity of the battery cell 110 based on a voltage of the battery cell 110. For example, the controller 220 may calculate the capacity of the battery cell 110 based on current applied to the battery cell 110 and a charging time during charging of the battery cell 110.

According to an embodiment, the controller 220 may calculate the battery profile P related to the capacity and the voltage of the battery cell 110. The battery profile P may include a relationship of the voltage of the battery cell 110 with respect to the capacity of the battery cell 110. For example, an x-axis of FIG. 3 may indicate a capacity (unit: Ah) and a y-axis may indicate a voltage (unit: V).

According to an embodiment, the controller 220 may calculate the battery profile P at each point in time of the lifetime of the battery cell 110. For example, the controller 220 may calculate the battery profile P in a beginning of life (BoL) state of the battery cell 110 and the battery profile P in a middle of life (MoL) state of the battery cell 110. According to an embodiment, the controller 220 may calculate the battery profile P in the BoL state of the battery cell 110 through experiment. For example, the controller 220 may calculate the battery profile P in the BoL state based on production specifications of the battery cell 110.

The battery profile P may be changed in a deterioration and degradation process of the battery cell 110. Thus, the controller 220 may compare the battery profile P in the BoL state of the battery cell 110 with the battery profile P in the MoL state to diagnose degradation of the battery cell 110.

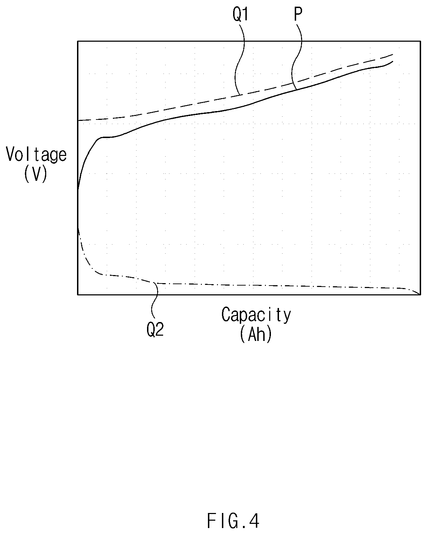

FIG. 4 shows a battery profile according to an embodiment disclosed herein.

Referring to FIG. 4, the controller 220 may separate a positive electrode profile Q1 and a negative electrode profile Q2 from the battery profile P of the battery cell 110. Thus, the controller 220 may calculate a positive electrode degradation degree to which the positive electrode of the battery cell 110 is degraded, based on the separated positive electrode profile Q1. Thus, the controller 220 may calculate a negative electrode degradation degree to which the negative electrode of the battery cell 110 is degraded, based on the separated negative electrode profile Q2. Herein, the degradation degree may refer to a degree to which a negative electrode or a positive electrode is degraded in comparison to the initial state of production.

According to an embodiment, the battery profile P shown in FIG. 3 may be separated into the positive electrode profile Q1 and the negative electrode profile Q2 shown in FIG. 4. The positive electrode profile Q1 and the negative electrode profile Q2 of FIG. 4 roughly show an X-Y graph when the capacity of the battery cell 110 is set as the x-axis and the voltage is set as the y-axis.

According to an embodiment, the controller 220 may separate the negative electrode profile Q2 or the positive electrode profile Q1 from the battery profile P based on any one of the positive electrode profile Q1 or the negative electrode profile Q2. For example, the controller 220 may separate the negative electrode profile Q2 based on the battery profile P and the positive electrode profile Q1. In another aspect, the controller 220 may separate the positive electrode profile Q1 based on the battery profile P and the negative electrode profile Q2. In this way, the controller 220 may separate, based on a profile (a voltage profile corresponding to the capacity) of a single electrode (e.g., the negative electrode) of the battery cell 110 and the battery profile P, a profile (a voltage profile corresponding to the capacity) of the other electrode (e.g., the positive electrode).

According to an embodiment, the controller 220 may calculate each of the positive electrode profile Q1 and the negative electrode profile Q2 by using an open circuit potential (OCP) of each of the positive electrode and the negative electrode of the battery cell 110. In this way, the controller 220 may separate the battery profile P into the positive electrode profile Q1 and the negative electrode profile Q2.

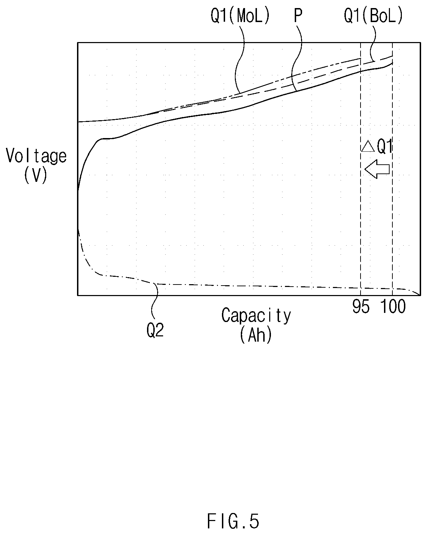

FIG. 5 shows a battery profile according to an embodiment disclosed herein.

Referring to FIG. 5, FIG. 5 shows a graph showing the battery profile P in the BoL state of the battery cell 110 and a positive electrode profile Q1 (MoL) in the MoL state of the battery cell 110. In FIG. 5, an x-axis may indicate a capacity (unit: Ah) and a y-axis may indicate a voltage (unit: V).

According to an embodiment, the controller 220 may compare the positive electrode profile Q1 (MoL) in the MoL state of the battery cell 110 with a reference positive electrode profile to calculate a positive electrode degradation degree of the battery cell 110. Herein, the positive electrode profile Q1 (MoL) in the MoL state may refer to the positive electrode profile of the degraded battery cell 110. The reference positive electrode profile may refer to the positive electrode profile of the battery cell 110 obtained at a reference point in time for calculating the degradation degree of the battery cell 110. For example, the reference positive electrode profile may refer to a positive electrode profile Q1 (BoL) in a state (i.e., the BoL state) where the battery cell 110 is not degraded.

According to an embodiment, the controller 220 may obtain the positive electrode profile Q1 (BoL) in the BoL state of the battery cell 110 through experiment. For example, the controller 220 may obtain the positive electrode profile Q1 (BoL) in the BoL state of the battery cell 110 based on production specifications of the battery cell 110. The controller 220 may obtain the positive electrode profile Q1 (BoL) in the BoL state of the battery cell 110 from an external device (e.g., a server).

According to an embodiment, the controller 220 may compare positive electrode profiles of the battery cell 110, respectively obtained at two different points in time, to calculate a positive electrode degradation degree of the battery cell 110 based on a degree △Q1 to which a capacity of the positive electrode profile is reduced. According to an embodiment, the controller 220 may calculate the positive electrode degradation degree of the battery cell 110 based on the degree △Q1 to which the capacity of the positive electrode profile Q1 (MoL) in the MoL state of the battery cell 110 is reduced in comparison to the capacity of the reference positive electrode profile (e.g., Q1 (BoL)).

According to an embodiment, the controller 220 may calculate the degree △Q1 to which the current capacity of the positive electrode profile of the battery cell 110 is reduced from a maximum capacity of positive electrode profiles of the battery cell 110 respectively obtained at two different points in time. Herein, the maximum capacity may refer to a capacity of the battery cell 110 in a state where the battery cell 110 is charged up to a chargeable capacity.

For example, when the maximum capacity of the positive electrode profile Q1 (BoL) in the BoL state of the battery cell 110 is 100 and the maximum capacity of the positive electrode profile Q1 (MoL) in the MoL state of the battery cell 110 is 95, the controller 220 may calculate the degree △Q1 to which the maximum capacity of the positive electrode profile is reduced by using a difference in maximum capacity between the positive electrode profiles. Herein, the degree △Q1 to which the maximum capacity of the positive electrode profile is reduced may be 5 that is a difference of 95 from 100.

According to an embodiment, the controller 220 may calculate a positive electrode degradation degree of 5 % based on the degree △Q1 to which the maximum capacity of the battery cell 110 is currently reduced. In this way, the controller 220 may diagnose the positive electrode degradation degree that is a degree to which the positive electrode is degraded in comparison to the initial state (BoL) of production of the battery cell 110 through repetition of charging and discharging of the battery cell 110.

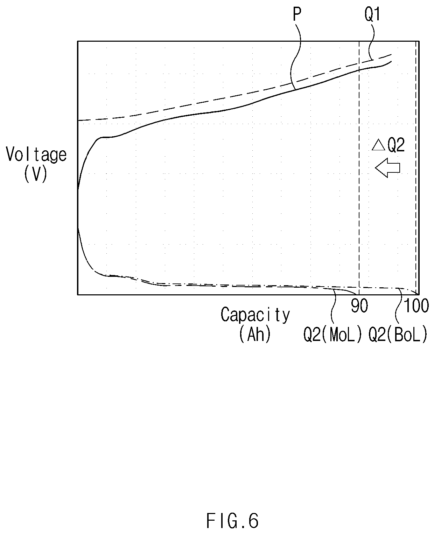

FIG. 6 shows a battery profile according to an embodiment disclosed herein.

Referring to FIG. 6, FIG. 6 shows a graph showing the battery profile P in the BoL state of the battery cell 110 and a negative electrode profile Q2 (MoL) in the MoL state of the battery cell 110. In FIG. 6, an x-axis may indicate a capacity (unit: Ah) and a y-axis may indicate a voltage (unit: V).

According to an embodiment, the controller 220 may compare the negative electrode profile Q2 (MoL) in the MoL state of the battery cell 110 with a reference negative electrode profile to calculate a negative electrode degradation degree of the battery cell 110. Herein, the reference negative electrode profile may refer to the negative electrode profile of the battery cell 110 obtained at a reference point in time for calculating the degradation degree of the battery cell 110. For example, the reference negative electrode profile may refer to a negative electrode profile Q2 (BoL) in a state (i.e., the BoL state) where the battery cell 110 is not degraded.

According to an embodiment, the controller 220 may obtain the negative electrode profile Q2 (BoL) in the BoL state of the battery cell 110 through experiment. For example, the controller 220 may obtain the negative electrode profile Q2 (BoL) in the BoL state of the battery cell 110 based on production specifications of the battery cell 110. The controller 220 may obtain the negative electrode profile Q2 (BoL) in the BoL state of the battery cell 110 from an external device (e.g., a server).

According to an embodiment, the controller 220 may compare negative electrode profiles of the battery cell 110, respectively obtained at two different points in time, to calculate a negative electrode degradation degree of the battery cell 110 based on a degree △Q2 to which a capacity of the negative electrode profile is reduced. According to an embodiment, the controller 220 may calculate the negative electrode degradation degree of the battery cell 110 based on the degree △Q2 to which the capacity of the negative electrode profile Q2 (MoL) in the MoL state of the battery cell 110 is reduced in comparison to the capacity of the reference negative electrode profile (e.g., Q2 (BoL)).

According to an embodiment, the controller 220 may calculate the degree △Q2 to which the current capacity of the negative electrode profile of the battery cell 110 is reduced from a maximum capacity of negative electrode profiles of the battery cell 110 respectively obtained at two different points in time. Herein, the maximum capacity may refer to a capacity of the battery cell 110 in a state where the battery cell 110 is charged up to a chargeable capacity.

For example, when the maximum capacity of the negative electrode profile Q2 (BoL) in the BoL state of the battery cell 110 is 100 and the maximum capacity of the negative electrode profile Q2 (MoL) in the MoL state of the battery cell 110 is 90, the controller 220 may calculate the degree ΔQ2 (=10) to which the maximum capacity of each negative electrode profile is reduced. In addition, the controller 220 may calculate a negative electrode degradation degree of 10 % based on the degree △Q2 (=10) to which the maximum capacity of the battery cell 110 is currently reduced. In this way, the controller 220 may diagnose the negative electrode degradation degree that is a degree to which the negative electrode is degraded in comparison to the initial state (BoL) of production of the battery cell 110 through repetition of charging and discharging of the battery cell 110.

Thus, the controller 220 may calculate a positive electrode degradation degree and a negative electrode degradation degree based on the battery profile P and identify degradation states of the positive electrode and the negative electrode of the battery cell 110 based on the calculated positive electrode degradation degree and negative electrode degradation degree. For example, the controller 220 may identify that a positive electrode active material collapses more or a by-product is generated in the positive electrode as the positive electrode degradation degree of the battery cell 110 increases. In another aspect, the controller 220 may identify that a positive electrode internal resistance increases as the positive electrode degradation degree of the battery cell 110 increases. On the other hand, the controller 220 may identify that lithium plating progresses more in the negative electrode as the negative electrode degradation degree of the battery cell 110 increases.

According to an embodiment, the controller 220 may determine a main degradation state between a degradation state of the positive electrode and a degradation state of the negative electrode of the battery cell 110. Based on the determined main degradation state, a charging profile of the battery cell 110 may be managed. Herein, the main degradation state may refer to a state having a greater influence upon degradation of the battery cell 110 between the degradation state of the positive electrode and the degradation state of the negative electrode.

According to an embodiment, the controller 220 may determine, as the main degradation state, a degradation state of the electrode having a higher degradation degree between the positive electrode degradation degree and the negative electrode degradation degree. For example, when the degradation degree of the positive electrode is 5 % and the degradation degree of the negative electrode is 10 %, the controller 220 may determine, as the main degradation state, the degradation state of the negative electrode having a higher degradation degree.

According to an embodiment, the controller 220 may manage the charging profile of the battery cell 110, based on the main degradation state. Herein, the charging profile of the battery cell 110 may include information about a strength (e.g., C-rate) of a charging current used for charging the battery cell 110. For example, the charging profile may include a profile indicating a correspondence between the capacity and the charging current of the battery cell 110. In another aspect, the charging profile may include a profile indicating a correspondence between the SOC and the charging current of the battery cell 110.

According to an embodiment, the charging profile may include a charging profile for slow charging or fast charging of the battery cell 110. For example, the charging profile may include a quick charge (QC) map for fast charging of the battery cell 110.

According to an embodiment, positive electrode degradation and negative electrode degradation of the battery cell 110 may cause different results in a charging operation of the battery cell 110. For example, negative electrode degradation of the battery cell 110 may accelerate capacity degradation of the battery cell 110 than positive electrode degradation in the charging operation. Thus, the controller 220 may manage the charging profile of the battery cell 110 according to the main degradation state to more accurately reflect the degradation state of the battery cell 110, thereby managing charging of the battery cell 110. In this way, the controller 220 may prevent further degradation from occurring due to fast charging of the battery cell 110.

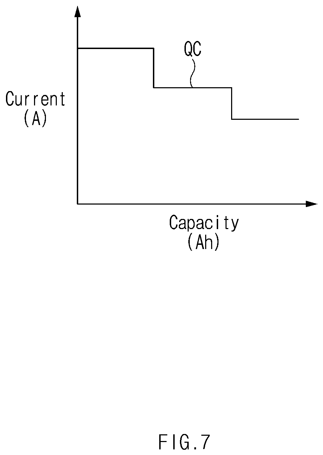

FIG. 7 shows a charging profile according to an embodiment disclosed herein.

Referring to FIG. 7, a charging profile QC may refer to an X-Y graph having the charging capacity (unit: Ah) of the battery cell 110 as an x axis and the charging current (unit: A) as a y axis. According to an embodiment, the charging profile QC may refer to a QC map for fast charging of the battery cell 110. Herein, the charging profile may indicate a relationship between a capacity and a charging current of a battery, used for charging of the battery cell 110. The charging current may refer to C-rate of fast charging.

The controller 220 may manage a charging profile based on a reference charging profile QC related to the battery cell 110 when the main degradation state is a degradation state of the positive electrode. Herein, the reference charging profile QC may refer to a charging profile related to a BoL state of the battery cell 110. For example, the reference charging profile QC may refer to a fast charging profile used for fast charging of the battery cell 110 not degraded. According to an embodiment, the controller 220 may obtain a charging profile in the BoL state through experiment and may obtain the charging profile in the BoL state from an external device (e.g., a server).

When the main degradation state is the degradation state of the positive electrode, a resistance of the positive electrode may increase in a charging period of the battery cell 110 and a slope of a voltage profile of the positive electrode may increase. Thus, in the charging period, the voltage of the battery cell 110 may quickly reach a charging rated voltage. Thus, the controller 220 may charge the battery cell 110 without accelerating degradation of the battery cell 110 even without changing the fast charging profile in the BoL state.

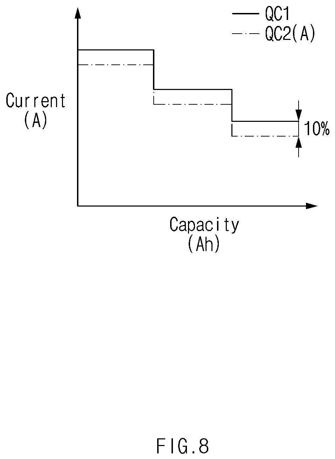

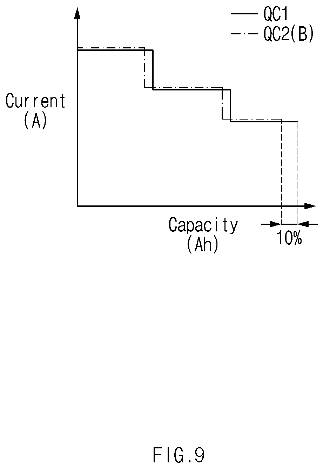

FIGS. 8 and 9 show a charging profile according to an embodiment disclosed herein.

Referring to FIGS. 8 and 9, a charging profile QC may refer to an X-Y graph having the charging capacity (unit: Ah) of the battery cell 110 as an x axis and the charging current (unit: A) as a y axis. According to an embodiment, the charging profile QC may refer to a QC map for fast charging of the battery cell 110. Herein, the charging profile may indicate a relationship between a capacity and a charging current (i.e., C-rate) of a battery, used for charging of the battery cell 110.

The controller 220 may manage the charging profile of the battery cell 110 based on a second charging profile QC2 when the main degradation state is a degradation state of the negative electrode. Herein, the second charging profile QC2 may refer to a charging profile reflecting the degradation state of the negative electrode. For example, the controller 220 may calculate the second charging profile QC2 based on the degradation state of the negative electrode.

According to an embodiment, the controller 220 may calculate the second charging profile QC2 based on a first charging profile QC1. Herein, the first charging profile QC1 may refer to a charging profile related to the BoL state of the battery cell 110, and the second charging profile QC2 may refer to a charging profile related to the MoL state of the battery cell 110. For example, the first charging profile QC1 may refer to a fast charging profile used for fast charging of the battery cell 110 not degraded, and the second charging profile QC2 may refer to a fast charging profile used for fast charging of the degraded battery cell 110. According to an embodiment, the controller 220 may obtain a charging profile in the BoL state through experiment and may obtain the charging profile in the BoL state from an external device (e.g., a server).

Lithium plating that is a main cause for negative electrode degradation may cause a short-circuit between electrodes inside the battery cell 110 and cause capacity reduction of the battery cell 110. For example, when the battery cell 110 is fast-charged using a charging profile related to the BoL state of the battery cell 110, capacity reduction of the battery cell 110 caused by degradation may not be reflected, further accelerating negative electrode degradation. Thus, the controller 220 may calculate the second charging profile QC2 reflecting the degradation state of the battery cell 110 when the degradation of the negative electrode is the main degradation state. For example, the controller 220 may change the charging profile related to the BoL state into the charging profile related to the MoL state. Through such an optimized charging profile, the controller 220 may reduce the speed of capacity degradation of the battery cell 110 and manage degradation of the battery cell 110.

According to an embodiment, the second charging profile QC2 may include two types of second charging profiles (e.g., QC2(A) or QC2(B)). A corresponding description will be made with reference to FIGS. 8 and 9.

Referring to FIG. 8, the controller 220 may change the charging current of the first charging profile QC1 related to the BoL state of the battery cell 110 to calculate the second charging profile QC2(A). Herein, the first charging profile QC1 may be a profile indicating a charging current corresponding to a capacity for fast charging in the BoL state of the battery cell 110. According to an embodiment, the controller 220 may reduce the charging current of the first charging profile QC1 by the negative electrode degradation degree, thereby calculating the second charging profile QC2(A). Herein, the charging current may refer to C-rate of fast charging.

According to an embodiment, the controller 220 may reduce the charging current of the first charging profile QC1 by the negative electrode degradation degree (10 %), thereby calculating the second charging profile QC2(A). For example, the controller 220 may fast-charge the battery cell 110 at C-rate reduced by the negative electrode degradation degree (e.g., 10 %) in comparison to C-rate in fast charging in the BoL state of the battery cell 110. The controller 220 may finish charging before lithium plating occurs by reducing C-rate by the negative electrode degradation degree in fast charging. In this way, by preventing lithium plating, the controller 220 may improve the depth of fast charging and manage degradation of the battery cell 110.

Referring to FIG. 9, the controller 220 may change the charging capacity of the first charging profile QC1 related to the BoL state of the battery cell 110 to calculate the second charging profile QC2(B). Herein, the first charging profile QC1 may be a profile indicating a charging current corresponding to a capacity for fast charging in the BoL state of the battery cell 110. According to an embodiment, the controller 220 may reduce the charging capacity of the first charging profile QC1 by the negative electrode degradation degree, thereby calculating the second charging profile QC2(B).

According to an embodiment, the controller 220 may reduce the charging capacity of the first charging profile QC1 by the negative electrode degradation degree (10 %), thereby calculating the second charging profile QC2(B). For example, the controller 220 may calculate, as the capacity of the battery cell 110 charged by a specific C-rate in fast charging, a capacity reduced by the negative electrode degradation degree (e.g., 10 %) in comparison to the BoL state of the battery cell 110. Thus, the controller 220 may finish charging before lithium plating occurs by reducing the charging capacity by the negative electrode degradation degree in fast charging. In this way, by preventing lithium plating, the controller 220 may improve the depth of fast charging and manage degradation of the battery cell 110.

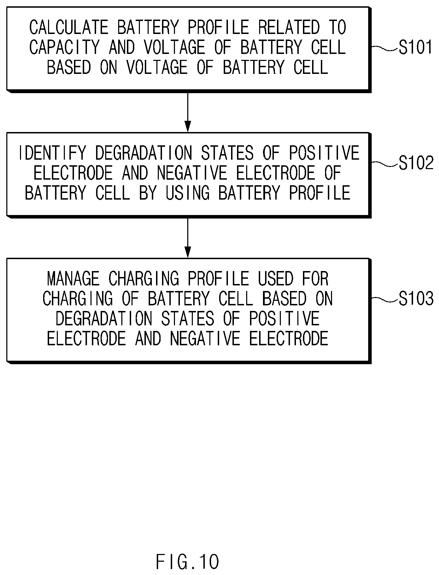

FIG. 10 is an operating flowchart of a battery management apparatus according to an embodiment disclosed herein.

Referring to FIG. 10, the battery management apparatus 200 may include operation S101 of calculating the battery profile P related to a capacity and a voltage of the battery cell 110 based on the voltage of the battery cell 110, operation S102 of identifying a degradation state of a positive electrode and a negative electrode of the battery cell 110 by using the battery profile P, and operation S103 of managing a charging profile used for charging of the battery cell 110 based on the degradation state of the positive electrode and the negative electrode. According to an embodiment, the operations of the battery management apparatus 200 may be performed by the controller 220.

In operation S101, the controller 220 may calculate the battery profile P related to the capacity and the voltage of the battery cell 110 based on the voltage of the battery cell 110. Herein, the voltage of the battery cell 110 may be obtained by the obtaining unit 210.

In operation S102, the controller 220 may identify the degradation states of the positive electrode and the negative electrode of the battery cell 110 by using the battery profile P. According to an embodiment, the controller 220 may calculate a positive electrode degradation degree to which the positive electrode of the battery cell 110 is degraded and a negative electrode degradation degree to which the negative electrode of the battery cell 110 is degraded, by using the battery profile P. According to an embodiment, the controller 220 may separate the positive electrode profile Q1 and the negative electrode profile Q2 from the battery profile P and calculate the positive electrode degradation degree and the negative electrode degradation degree based on a degree to which the capacities of the positive electrode profile Q1 and the negative electrode profile Q2 are reduced when compared to capacities of a reference positive electrode profile and a reference negative electrode profile. The controller 220 may then identify the degradation states of the positive electrode and the negative electrode based on the positive electrode degradation degree and the negative electrode degradation degree.

In operation S103, the controller 220 may manage a charging profile used for charging of the battery cell 110 based on the degradation states of the positive electrode and the negative electrode.

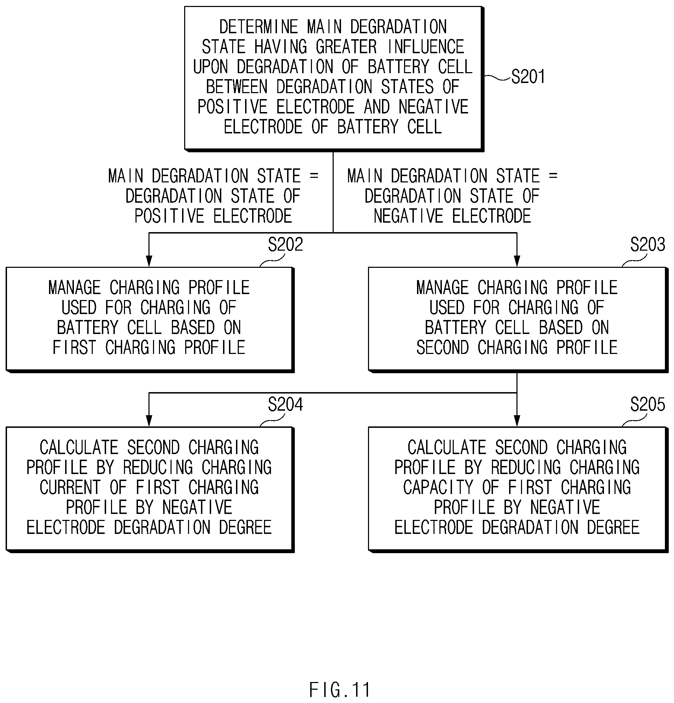

FIG. 11 is an operating flowchart of a battery management apparatus according to an embodiment disclosed herein.

Referring to FIG. 11, the battery management apparatus 200 may include operation S201 of determining a main degradation state that has a greater influence upon degradation of the battery cell 110 between a degradation state of the positive electrode of the battery cell 110 and a degradation state of the negative electrode of the battery cell 110, operation S202 of managing a charging profile used for charging of the battery cell 110 based on the first charging profile QC1 related to the battery cell 110 when the main degradation state is the degradation state of the positive electrode, operation S203 of managing the charging profile used for charging of the battery cell 110 based on the second charging profile QC2 that is a charging profile reflecting the degradation state of the negative electrode when the main degradation state is the degradation state of the negative electrode, operation S204 of calculating the second charging profile QC2 by reducing the charging current of the first charging profile QC1 by the negative electrode degradation degree, and operation S205 of calculating the second charging profile QC2 by reducing the charging capacity of the first charging profile QC1 by the negative electrode degradation degree.

In operation S201, the controller 220 may determine the main degradation state that has the greater influence upon degradation of the battery cell 110 between the degradation states of the positive electrode and the negative electrode of the battery cell 110. According to an embodiment, the controller 220 may determine, as the main degradation state, the degradation state of the electrode having the higher degradation degree between the positive electrode degradation degree and the negative electrode degradation degree.

In operation S202, the controller 220 may manage the charging profile used for charging of the battery cell 110 based on the first charging profile QC1 related to the battery cell 110 when the main degradation state is the degradation state of the positive electrode. According to an embodiment, the controller 220 may fast-charge the battery cell 110 by managing the charging profile while maintaining the fast charging profile in the BoL state of the battery cell 110.

In operation S203, the controller 220 may manage the charging profile used for charging of the battery cell 110 based on the second charging profile QC2 that is a charging profile reflecting the degradation state of the negative electrode when the main degradation state is the degradation state of the negative electrode. According to an embodiment, the controller 220 may fast charge the battery cell 110 by using the second charging profile QC2 that changes the fast charging profile in the BoL state of the battery cell 110.

In operation S204, the controller 220 may reduce the charging current of the first charging profile QC1 by the negative electrode degradation degree, thereby calculating the second charging profile QC2.

In operation S205, the controller 220 may reduce the charging capacity of the first charging profile QC1 by the negative electrode degradation degree, thereby calculating the second charging profile QC2.

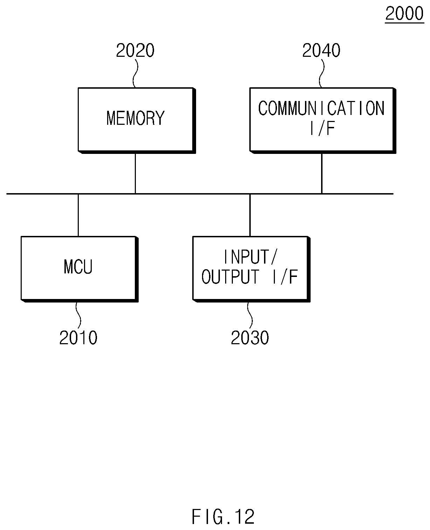

FIG. 12 is a block diagram showing a hardware configuration of a computing system for performing an operating method of a battery management apparatus, according to an embodiment disclosed herein.

Referring to FIG. 12, a computing system 2000 according to an embodiment disclosed herein may include a microcontroller unit (MCU) 2010, a memory 2020, an input/output interface (I/F) 2030, and a communication I/F 2040.

The MCU 2010 may be a processor that executes various programs (e.g., a battery cell feature data collection program, a battery profile generating program, a battery cell diagnosis program, etc.) stored in the memory 2020, processes various information including battery cell feature data and battery cell state data through these programs, and executes the above-described functions of the controller 220 included in the battery management apparatus 200 shown in FIG. 2.

The memory 2020 may store various programs performed by the MCU 2010, such as the battery cell feature data collection program, the battery profile generating program, the battery cell diagnosis program, etc. The memory 2020 may store various information including the battery cell feature data, the battery cell state data, a battery cell parameter, a battery degradation degree, etc.

The memory 2020 may be provided in plural, depending on a need. The memory 2020 may be a volatile or nonvolatile memory. For the memory 2020 as the volatile memory, random access memory (RAM), dynamic RAM (DRAM), static RAM (SRAM), etc., may be used. For the memory 2020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2020 are merely examples and are not limited thereto.

The input/output I/F 2030 may provide an interface for transmitting and receiving data by connecting an input device (not shown) such as a keyboard, a mouse, a touch panel, etc., and an output device such as a display (not shown), etc., with the MCU 2010.

The communication I/F 2040, which is a component capable of transmitting and receiving various data to and from a server, may be various types of devices capable of supporting wired or wireless communication. For example, the battery management apparatus 200 may transmit and receive various information including SOC, OCV, parameter, etc., of the battery cell from an external server separately provided through the communication I/F 2040.

As such, a computer program according to an embodiment disclosed herein may be recorded in the memory 2020 and processed by the MCU 2010, thus being implemented as a module that performs functions shown in FIG. 2.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure, and various changes, substitutions, and modifications may be made herein without departing from the scope of the present disclosure.

### [Explanation of Reference Numerals Designating Major Elements of Drawings]

100: BATTERY CELL MODULE
110, 120, 130, 140: BATTERY CELL
200: BATTERY MANAGEMENT APPARATUS
300: RELAY
210: OBTAINING UNIT
220: CONTROLLER
1000: BATTERY CELL PACK
2000: COMPUTING SYSTEM
2010: MCU
2020: MEMORY
2030: INPUT/OUTPUT I/F
2040: COMMUNICATION I/F

## Claims

1. A battery management apparatus comprising:
an obtaining unit configured to obtain a voltage of a battery cell; and
a controller configured to:
calculate a battery profile related to a capacity and the voltage of the battery cell, based on the voltage of the battery cell;
identify degradation states of a positive electrode and a negative electrode of the battery cell, by using the battery profile; and
manage a charging profile used for charging of the battery cell based on the degradation states of the positive electrode and the negative electrode.

2. The battery management apparatus of claim 1, wherein the controller is further configured to:
calculate a positive electrode degradation degree that is a degree to which the positive electrode of the battery cell is degraded and a negative electrode degradation degree that is a degree to which the negative electrode of the battery cell is degraded, based on the battery profile; and
identify the degradation states of the positive electrode and the negative electrode based on the positive electrode degradation degree and the negative electrode degradation degree.

3. The battery management apparatus of claim 2, wherein the controller is further configured to:
separate a positive electrode profile and a negative electrode profile from the battery profile; and
calculate the positive electrode degradation degree and the negative electrode degradation degree based on a degree to which capacities of the positive electrode profile and the negative electrode profile are reduced in comparison to capacities of a reference positive electrode profile and a reference negative electrode profile.

4. The battery management apparatus of claim 2, wherein the controller is further configured to:
determine a main degradation state that has a greater influence upon degradation of the battery cell between the degradation states of the positive electrode and the negative electrode of the battery cell; and
manage the charging profile based on the main degradation state.

5. The battery management apparatus of claim 4, wherein the controller is further configured to determine, as the main degradation state, a degradation state of an electrode having a greater degradation degree between the positive electrode degradation degree and the negative electrode degradation degree.

6. The battery management apparatus of claim 4, wherein the controller is further configured to manage a charging profile used for charging of the battery cell based on a first charging profile related to the battery cell, when the main degradation state is the degradation state of the positive electrode.

7. The battery management apparatus of claim 6, wherein the first charging profile comprises a charging profile related to a beginning of life (BoL) state of the battery cell.

8. The battery management apparatus of claim 4, wherein the controller is further configured to manage a charging profile used for charging of the battery cell based on a second charging profile that reflects the degradation state of the negative electrode when the main degradation state is the degradation state of the negative electrode.

9. The battery management method of claim 8, wherein the controller is further configured to calculate, based on a first charging profile indicating a charging current corresponding to the capacity of the battery cell related to the BoL state of the battery cell, the second charging profile by reducing the charging current of the first charging profile by the negative electrode degradation degree.

10. The battery management method of claim 8, wherein the controller is further configured to calculate, based on a first charging profile indicating a charging current corresponding to the capacity of the battery cell related to the BoL state of the battery cell, the second charging profile by reducing the capacity of the first charging profile by the negative electrode degradation degree.

11. The battery management apparatus of claim 1, wherein the charging profile indicates a correspondence between the capacity and the charging current of the battery cell for fast charging of the battery cell.

12. A battery management method comprising:
calculating a battery profile related to a capacity and a voltage of a battery cell, based on the voltage of the battery cell;
identifying degradation states of a positive electrode and a negative electrode of the battery cell, by using the battery profile; and
managing a charging profile used for charging of the battery cell based on the degradation states of the positive electrode and the negative electrode.

13. The battery management method of claim 12, wherein the identifying of the degradation states of the positive electrode and the negative electrode of the battery cell comprises:
calculating a positive electrode degradation degree that is a degree to which the positive electrode of the battery cell is degraded and a negative electrode degradation degree that is a degree to which the negative electrode of the battery cell is degraded, based on the battery profile; and
identifying the degradation states of the positive electrode and the negative electrode based on the positive electrode degradation degree and the negative electrode degradation degree.

14. The battery management method of claim 13, wherein the calculating of the positive electrode degradation degree and the negative electrode degradation degree comprises:
separating a positive electrode profile and a negative electrode profile from the battery profile; and
calculating the positive electrode degradation degree and the negative electrode degradation degree based on a degree to which capacities of the positive electrode profile and the negative electrode profile are reduced in comparison to capacities of a reference positive electrode profile and a reference negative electrode profile.

15. The battery management method of claim 13, wherein the managing of the charging profile comprises:
determining a main degradation state that has a greater influence upon degradation of the battery cell between the degradation states of the positive electrode and the negative electrode of the battery cell; and
managing the charging profile based on the main degradation state.

16. The battery management method of claim 15, wherein the determining of the main degradation state comprises determining, as the main degradation state, a degradation state of an electrode having a greater degradation degree between the positive electrode degradation degree and the negative electrode degradation degree.

17. The battery management method of claim 15, wherein the managing of the charging profile comprises managing a charging profile used for charging of the battery cell based on a first charging profile related to the battery cell, when the main degradation state is the degradation state of the positive electrode.

18. The battery management method of claim 15, wherein the managing of the charging profile comprises managing a charging profile used for charging of the battery cell based on a second charging profile that reflects the degradation state of the negative electrode when the main degradation state is the degradation state of the negative electrode.

19. The battery management method of claim 18, further comprising calculating, based on a first charging profile indicating a charging current corresponding to the capacity of the battery cell related to the BoL state of the battery cell, the second charging profile by reducing the charging current of the first charging profile by the negative electrode degradation degree.

20. The battery management method of claim 18, further comprising calculating, based on a first charging profile indicating a charging current corresponding to the capacity of the battery cell related to the BoL state of the battery cell, the second charging profile by reducing the capacity of the first charging profile by the negative electrode degradation degree.
